Europäisches Patentamt

(19) European Patent Office

Office européen des brevets

(11) Publication number: **0 170 706**
**B1**

(12) **EUROPEAN PATENT SPECIFICATION**

(45) Date of publication of patent specification: **15.03.89**

(21) Application number: **84107011.3**

(22) Date of filing: **19.06.84**

(51) Int. Cl.⁴: **B 65 G 59/06, H 05 K 13/02**

(54) **A frame separator.**

(43) Date of publication of application:
**12.02.86 Bulletin 86/07**

(45) Publication of the grant of the patent:
**15.03.89 Bulletin 89/11**

(84) Designated Contracting States:
**AT BE CH DE FR GB IT LI LU NL SE**

(56) References cited:
**FR-A- 950 966**
**GB-A- 964 314**
**GB-A-1 175 668**
**US-A-2 426 887**
**US-A-2 699 862**
**US-A-3 016 540**

(73) Proprietor: **SEIEI KOHSAN CO.,LTD.**
**1325-3, Tajima**
**Urawa-shi Saitama (JP)**

(72) Inventor: **Shimizu, Katsuo**
**No. 1325-3, Tajima**
**Urawa-shi Saitama (JP)**

(74) Representative: **Klingseisen, Franz, Dipl.-Ing.**
**et al**
**Dr. F. Zumstein sen. Dr. E. Assmann Dr. F.**
**Zumstein jun. Dipl.-Ing. F. Klingseisen**
**Bräuhausstrasse 4**
**D-8000 München 2 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention relates to a device for pushing out frames or the like one-by-one according to the preamble of claim 1.

US—A—3,016,540 shows a wafer feed and positioning mechanism of this kind. In the lower part of the magazine upper and lower pawls are provided which are movable only in horizontal direction. For aligning the wafers guiding rods are provided on the magazine, however, it is possible that a wafer is not positioned exactly in relation to the upper pawls between which the wafer must be clamped for the separating operation.

In the field of devices for separating IC lead frames, boards and the like, conventional devices are equipped with a vacuum sucker which often does not work satisfactorily or causes damages on the surface of the frame, boards or the like.

It is the object of the invention to provide a device of the before-mentioned kind which exactly and automatically separates frames, boards and the like one-by-one from a stack, and which may be incorporated into an automatic line.

This object is achieved by the features in the characterizing part of claim 1.

An example of the invention is described in more detail in connection with the enclosed drawings.

Fig. 1 is a perspective view of a device according to the invention;

Fig. 2 is a front side view;

Fig. 3 is a plan view;

Fig. 4 is a bottom view of a frame separator;

Figs. 5 and 6 are vertical and cross sectional views of the frame separation, showing different positions; and

Fig. 7 is an explanatory view of separating operation.

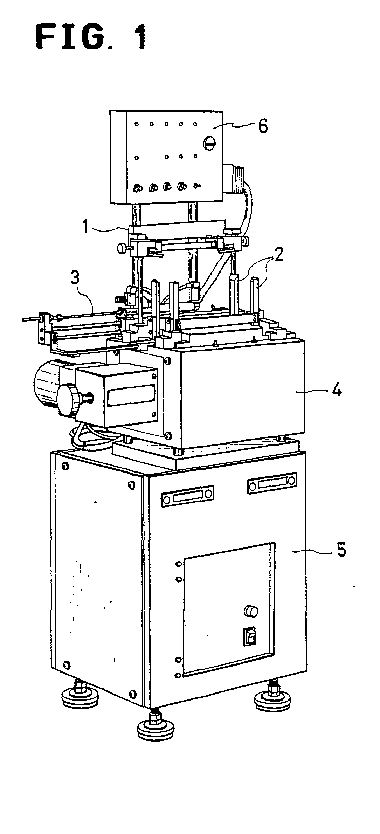

Fig. 1 shows an outside of a device according to the invention, and illustrates a stack-pressing mechanism 1 a magazine 2, a pusher mechanism 3, a separating mechanism 4, a bed 5, and an operating panel 6. The stack-pressing mechanism 1 presses a stack 8 within the magazine 2 to provide separating operation exactly.

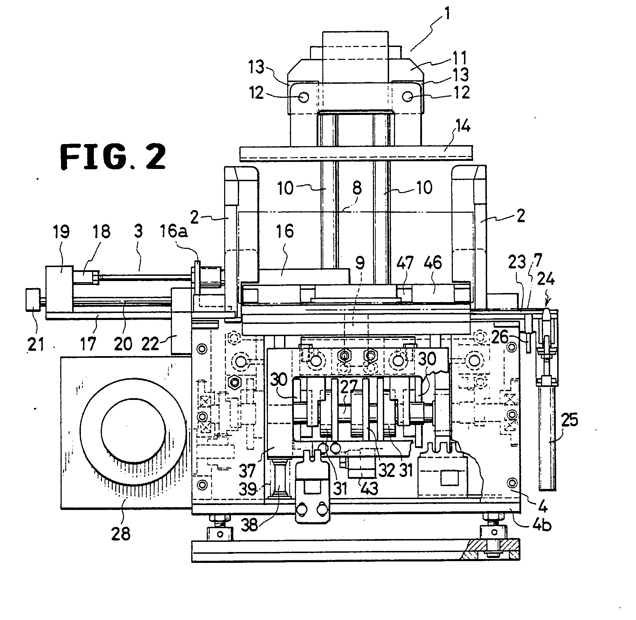

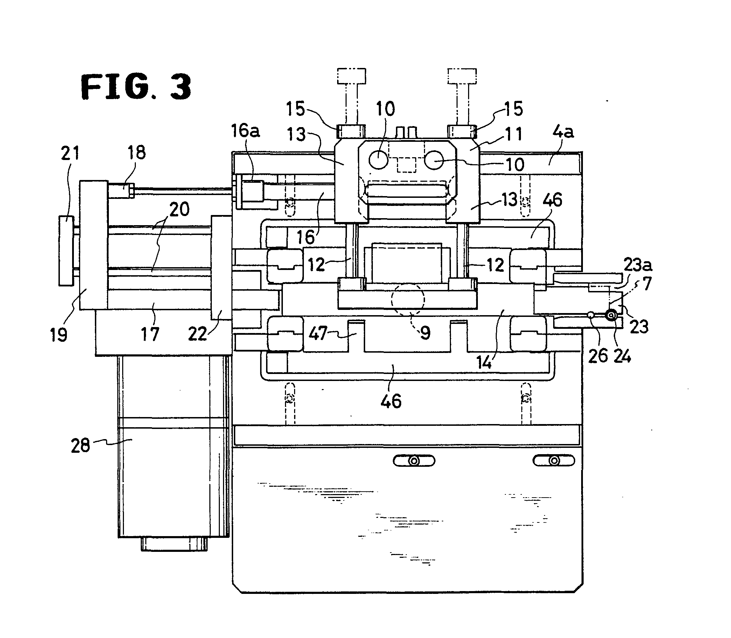

An explanation will be made to an actual embodiment with reference to Figs. 2 and 3. 10 are guide posts provided on a top panel 4a of the separating mechanism 4, and an elevating block 11 is vertically movable thereto. The elevating block 11 is provided with a coupling of sliding tubes 13 for slidably inserting arms 12 laterally. The arms 12 suspend and position a pressure plate 14 from their ends, which has the same dimension as the frame or work 7, while stoppers 15 are secured at their rear ends, and prevent the arms 12 from slipping down from the elevating block 11. The shown pressure plate 14 goes down along the guide posts 10 while pressing the stack due to its own weight, and it goes upward along the guide posts 10 by manual operation for supplying the stack 8. Instead of the manual operation, such a manner may be adopted that a screw shaft is installed which is rotated intermittently by a stepping motor, and the elevating block 11 is formed with a female screw for engaging with said screw shaft, so that the pressure plate 14 is vertically moved automatically. The magazine 2 comprises four standing members which have diameters in cross sectional shape, and hold only four corners of the stack 8.

A next reference will be made to the pusher mechanism 3 with Figs. 2 and 3. Reference numeral 16 is a cylinder for reciprocating a pusher 17, which is provided to the top plate 4a of the separator 4 by means of a cylinder bracket 16a and connects an end of a cylinder rod to a pusher holder 19 via an adjuster 18. The pusher 17 is plain and is secured at a lower side of the end of the pusher holder 19 into which a pair of guide rods 20 are slidable and stable thereby. Guide rods 20 are connected at their outsides via a stopper 21 and fixed to a pusher guide 22 at their insides, which are provided at an upper side of a side wall of the separator 4. The pusher guide 22 is formed with guide holes for reciprocating the pusher 17 in the normal direction.

Reference numeral 23 is a chute on which the work 7 pushed by the pusher 17 gets at its front end, and a positioning pin 24 goes in and out at the end point of the chute 23. The positioning pin 24 is tapered as seen in Fig. 2 and moved vertically by a cylinder 25 installed under the chute 23. Further the chute 23 is provided with a sensor 26 for detecting the work 7 moving, in front of the positioning pin 24. The chute 23 is formed with a cutout 23a. The cutout 23a is served in that a work loading means (not shown) comes under the cutout and inserts a catching pin in a hole opened in an edge of the work 7 for getting it out. A detector of double pieces of the work is installed in the frame separator 4.

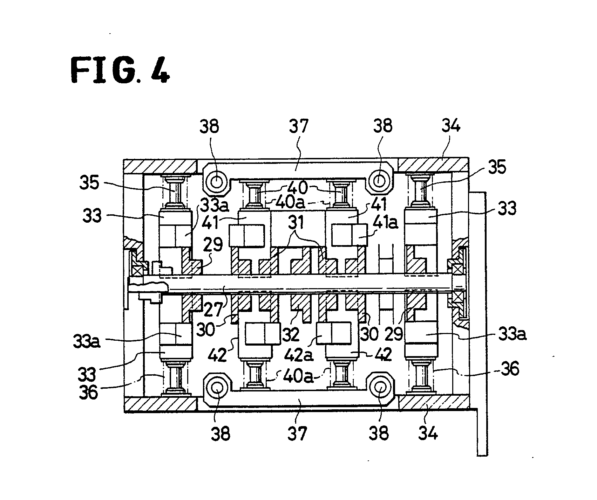

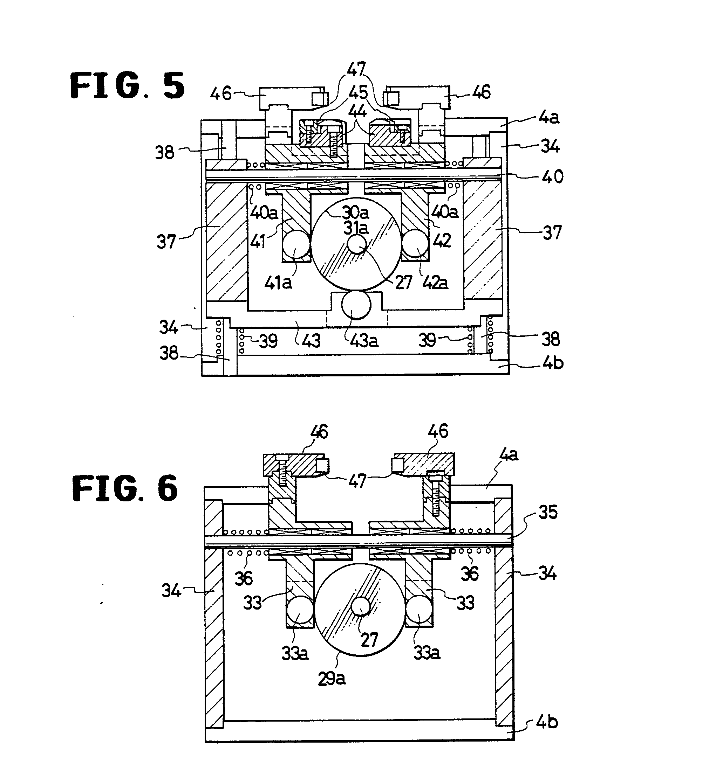

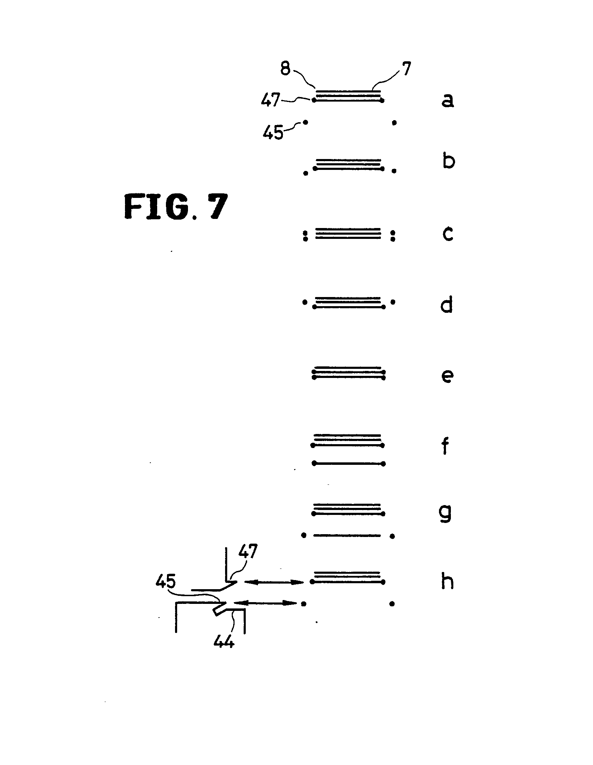

A structure of the frame separator 4 will be explained with Figs. 2 to 6. In the separator 4, upper and lower chacks have pawls for removing the work 7, and they are regularly opened and closed by means of cam mechanism. Reference numeral 27 is a cam shaft to be rotated by a speed control motor 28, which is secured with upper chack cams 29, right lower chack cams 30, left lower chack cams 31, and an elevating cam 32. Those cams are balanced in that the elevating cam 32 is centrally disposed with the left lower chack cams 31 at the both sides, the right lower chack cams 30 at their outsides, and the upper chack cams 29 at their further outsides. Reference numeral 33 is upper chack holders having cam followers 33 for connecting the upper chack cams 29. The upper chack holders 33 are slidable along a slide guide 35 bridging between side plates 34 and 34. Springs 36 are mounted on the slide guide 35, pressing the upper chack holders 33 toward the cam shaft 27 and pressing the cam followers 33a to the upper chack cams 29. Elevating plates 37 are provided at the left and right of the separator 4 for sliding supports 38 between the top plate 4a and a bottom plate 4b. The elevating plate 37 is pushed upwardly by a spring 39. Between the elevating plates 37, slide guides 40, 40 are provided and slidable in right lower chack holder 41 which are installed with cam followers 41a to right lower chack cams 30. Left lower chacks 42 also slidably insert slide guides 40, and installed with cam followers 42a to left lower chack cams 31. The lower chack holders 41, 42 are normally pressed to the cam shaft 27. A connector 43 connects the elevating plates 37 at their lower parts and is provided with a cam follower 43a contacting an elevating cam 32 for elevating the plates 37. Lower pawl bases 44 are secured on the lower chack holders 41, 42 having lower pawls 45. A distance between the upper surface of the base 44 and the pointed end of the pawl 45 is equal to a thickness of a piece of the work 7 (refer to Fig. 7). Upper pawl bases 46 are secured on the upper chack holders 33 and have upper pawls 47.

A detecting head 9 of the double pieces detector positions its head slightly under the work 7 on the lower pawl base 4, and fixes it to either of left or right lower chack holders. The detector detects double pieces of the work by, for example, changing in capacity of static electricity.

Operation

The stack 8 is set in the magazine 2 in that the pressure plate 14 is lifted along the guide posts 10 by mechanical or manual force, and the pressure plate 14 is pushed laterally. Then a couple of the arms 12 slide backward within the tubes 13 (phantom line in Fig. 3) and the pressure plate 14 is got out from the magazine 2, whereupon the stack 8 is charged within the magazine 2. The pressure plate 14 is pulled out and moved down on the stack 8. The stoppers 15 are positioned at the rear sides of the arms 12, so that the pressure plate 14 may be pulled out till the normal position. Thereafter, the pressure plate 14 continuously presses the stack 8 by its own weight.

A next reference will be made to separation of the stack piece by piece. The lower chack holders 41, 42 are mounted on the slide guides 40, 40 between the elevating plates 37, and they are moved vertically in accordance with actuation of the elevating plates 37. That is, when the elevating cam 32 does not act on the cam follower 43a, the plate 37 is pushed upward by the spring 39, and the lower chack holders 41, 42 are lifted up. Then due to the relation between the lower chack cams 30, 31 and the cam followers 41a, 42a, the lower chack holders 41, 42 are pushed outside against the pushing force of the spring 40a, and open (Fig. 7(b)). On the other hand, since the upper chack holders 33 are not influenced with action of the upper chack cams 29, 29 to the cam followers 33a, they are pushed inward by the springs 36 and shut (Fig. 7(b)). Subsequently, if the upper chack cams 29 progress in rotation in accompany with rotation of the cam shaft 27, the upper chack holders 33, 33 are opened outward via the cam followers 33a. Then the stack 8 on the upper pawls 47 moves on the lower pawl bases 44 (Fig. 7(c)). The lower pawl bases 44 are opened, since the left and right lower chack cams 30, 31 act on the cam followers 41a, 42a, but when this action is released, the lower chack holder 41, 42 are pushed inward by the springs 40a, and come nearly. As a result, since the space between the lower pawl base 44 and the lower pawl 45 is equal to the thickness of one piece of the work, the lower pawl 45 enters between the lowest work and the work on it, and separates the lowest work (Fig. 7(d)). Thereby the separated work 7 stays on the lower pawl base 44 under the chacked condition, and the stack or other laminated frames 8 exist on the lower pawl 45. When the action of the upper chack cam 29 to the cam follower 33a is finished under such a condition, the upper chack holders 33, 33 are pushed inward by the springs 36 and closed, and the upper pawl 47 at the same level as the lower pawl 45 enters under the laminated work 8 and receives it (Fig. 7(e)). When the elevating cam 32 acts on the cam follower 43a, the lower chack holders 41, 42 are moved down via the connector 43, the guide plate 37 and the slide guides 40 (Fig. 7(f)). At the same time, the lower chack cams 30, 31 act on the cam followers 41a, 42a to open the lower chack holders 41, 42. Then, the separated work 7 is made free on the lower pawl base 44 (Fig. 7(g)). The cylinder 16 is worked to advance the pusher 17 within the work stocker 2 and to push the work 7 on the lower pawl base 44 outside of the magazine 2 (Fig. 7(h) and (a)). The pushing amount is adjusted by an adjuster 18. On retreat of the pusher 17, the cylinder 25 is worked to lift the positioning pin 24. Since the positioning pin is tapered the tapered part of which the work 7 contacts on during lifting of the pin 24, the work 7 goes backward until the pin 24 stops lifting, and it is set at a determined position. If two pieces of the work are separated by error, the detector finds it out and stops the operation of the cylinder 16. The work delaminated properly is got out by a work loading means (not shown), and when its rear end passes on the sensor 26, the initial operation is begun to response to a signal from the sensor 26. The above mentioned continuous operation is made per one rotation of the cam shaft 27, and every time the cam shaft 27 is rotated, the delaminated work 7 is pushed out. The same operation as mentioned above is repeated.

The invention is as mentioned above, and the closely stack is exactly separated automatically piece by piece. If any separation is made by error, it is detected automatically, so that the operation is smooth and efficient, and this is easily incorporated into the automatic line.

**Claims**

1. A device for pushing out frames (7) or the like one-by-one from a stack (8) comprising a pusher mechanism (3) and a magazine (2) which holds said stack (8) of frames (7) on a support which is embodied as a separating mechanism for the lowest frame (7) in the stack (8), the separating mechanism comprising upper and lower pawls (45, 47) which are movable in horizontal direction, characterized in that a stack-pressing mechanism (14) is provided for continuously pressing the stack within the magazine (2), that the lower pawls (45) are movable in vertical direction for separating a frame (7) from the bottom of the stack (8) and for feeding this frame in front of the pusher mechanism (3), whereas the upper pawls (47) support the stack (8), and that a detector (9) is provided for detecting two frames fed in front of the pusher mechanism and for stopping the operation of the pusher mechanism (3) as well as a stop (24) for positioning end points of the frame (7) pushed out by the pusher mechanism (3) for exact operation of the device, the stop (24) being embodied as a tapered reciprocating position pin.

2. Device according to claim 1, characterized in that the stack-pressing mechanism (4) moves down under gravity and presses the stack (8) of frames (7).

3. Device according to claim 1, characterized in that the amount of pushing the frame by the pusher mechanism (3) is adjustable.

4. Device according to claim 1, characterized in that the detector (9) detects the separation of two frames (7) together by changing in capacity of static electricity.

**Patentansprüche**

1. Vorrichtung zum Ausstoßen von Montageplatten (7) oder dergleichen eine nach der anderen von einem Stapel (8), mit einem Stoßmechanismus (3) und einem Magazin (2), das den Stapel (8) von Montageplatten (7) auf einem Träger hält, der als Separiermechanismus für die unterste Montageplatte (7) in dem Stapel (8) ausgebildet ist, wobei der Separiermechanismus obere und untere Klauen (45, 47) umfaßt, die in horizontaler Richtung beweglich sind, dadurch gekennzeichnet, daß ein Stapelpreßmechanismus (14) zum kontinuierlichen Ausüben eines Drucks auf den Stapel in dem Magazin (2) vorgesehen ist, daß die unteren Klauen (45) zum Abtrennen einer Montageplatte (7) vom Boden des Stapels (8) und zum Zuführen dieser Montageplatte vor den Stoßmechanismus (3) in vertikaler Richtung beweglich sind, während die oberen Klauen (47) den Stapel (8) abstützen, und daß ein Detektor (9) zum Feststellen zweier vor den Stoßmechanismus beförderter Montageplatten und zum Anhalten des Betriebs der Stoßmechanismus (3) sowie ein Anschlag (24) zur Positionierung von Endpunkten der durch den Stoßmechanismus (3) ausgestoßenen Montageplatte (7) für einen exakten Betrieb der Vorrichtung vorgesehen ist, wobei der Anschlag (24) als konischer, hin- und herbeweglicher Positionierstift ausgebildet ist.

2. Vorrichtung nach Anspruch 1, dadurch gekennzeichnet, daß der Stapelpreßmechanismus (14) sich unter Schwerkraft nach unten bewegt und auf den Stapel (8) von Montageplatten (7) drückt.

3. Vorrichtung nach Anspruch 1, dadurch gekennzeichnet, daß der Hubweg des Stoßmechanismus (3) zum Ausstoßen der Montageplatte einstellbar ist.

4. Vorrichtung nach Anspruch 1, dadurch gekennzeichnet, daß der Detektor (9) die Abtrennung von zwei Montageplatten (7) zusammen durch Änderung in der Kapazität der statischen Elektrizität feststellt.

**Revendications**

1. Un dispositif pour faire sortir par poussée des montures (7) ou analogues, une par une, d'une pile (8), comprenant un mécanisme de poussée (3) et un magasin (2) qui maintient ladite pile (8) de montures (7) sur un support constitué par un mécanisme de séparation pour la monture (7) se trouvant le plus bas dans la pile (8), le mécanisme de séparation comprenant des mâchoires supérieures et inférieures (45, 47) qui sont mobiles en direction horizontale, caractérisé en ce qu'un mécanisme presseur de pile (14) est prévu pour presser de façon continue la pile dans la magasin (2) les mâchoires inférieures (45) sont mobiles en direction verticale pour séparer une monture (7) du fond de la pile (8) et pour envoyer cette monture à l'avant du mécanisme de poussée (3), alors que les mâchoires supérieures (47) supportent la pile (8), et en ce qu'un détecteur (9) est prévu pour détecter deux montures introduites à l'avant du mécanisme de poussée pour arrêter le fonctionnement du mécanisme de poussée (3), ainsi qu'une butée (24) pour positionner les points d'extrémité de la monture (7) qui est sortie par poussée par le mécanisme de poussée (3) en vue d'un fonctionnement précis du dispositif, la butée (24) étant constituée sous forme d'une tige de positionnement conique pouvant effectuer un mouvement de va-et-vient.

2. Le dispositif selon la revendication 1, caractérisé en ce que le mécanisme de pression de pile (14) descend par gravité et presse la pile (8) de montures (7).

3. Le dispositif selon la revendication 1, caractérisé en ce que la distance de poussée des montures par le mécanisme de poussée (3) est réglable.

4. Le dispositif selon la revendication 1, caractérisé en ce que le détecteur (9) détecte la séparation de deux montures (7) l'une de l'autre par modification de capacité électrique statique.

# FIG. 1

FIG. 2

# FIG. 3

# FIG. 4

# FIG. 5

# FIG. 6

5

**FIG. 7**

a

b

c

d

e

f

g

h